# DEMANDE DE BREVET EUROPEEN

(11) **EP 1 674 875 A1**
(43) Date de publication de la demande: **28.06.2006**
(21) Numéro de dépôt: 05112078.0
(22) Date de dépôt: 13.12.2005
(51) Int. Cl.: G01R 31/28, G01R 31/01, G11C 7/24, G11C 29/52, G01R 31/317

(54) **Invalidation d'un circuit intégré**

(30) Priorité: 14.12.2004 FR 0452964
(71) Demandeur: ST MICROELECTRONICS S.A., 92120 Montrouge (FR)
(72) Inventeur: MARINET, Fabrice, 13790, CHATEAUNEUF LE ROUGE (FR)
(74) Mandataire: de Beaumont, Michel

(57) **Abrégé**

L'invention concerne un procédé et un circuit de protection d'au moins un élément (41) d'un circuit intégré (20), conditionnant le fonctionnement de l'élément à protéger, à l'état d'un signal (VAL) conditionné par un élément à programmation irréversible dont l'état est fixé lors d'un test sous pointes du circuit intégré.

## Description

### Domaine de l'invention

La présente invention concerne de façon générale les circuits intégrés et plus particulièrement la protection d'informations contenues dans des puces de circuits intégrés rejetées lors de tests des circuits.

L'invention s'applique plus particulièrement aux circuits contenant un microcontrôleur.

### Exposé de l'art antérieur

La fabrication des circuits intégrés s'effectue par plaquettes (wafers) contenant plusieurs circuits. Une fois fabriquées, les plaquettes sont testées, c'est-à-dire que les différents circuits subissent une série de tests fonctionnels au moyen d'outils de test du type à cartes à pointes. Ces tests permettent d'éliminer les circuits défaillants avant les étapes de mise en boîtier.

En pratique, les circuits sont testés les uns après les autres ou par groupes et ceux qui sont identifiés comme défaillants sont marqués (généralement au moyen d'une goutte d'encre). Par la suite, une fois la plaquette découpée pour individualiser les circuits, le marquage est détecté optiquement pour rejeter les circuits défaillants. En fait, ces circuits sont laissés sur un disque support (tape) servant à la découpe d'où seuls sont prélevés pour mise en boîtier les circuits corrects.

Un problème apparaît lorsque les circuits intégrés contiennent, par fabrication, des informations considérées comme sensibles ou devant rester secrètes. Il peut s'agir de clés sécrètes ou de fonctions (algorithmes de calcul) spécifiques qui sont fixées à la fabrication (par exemple, par masque).

Les éléments secrets sont présents à la fois dans les circuits valables et dans les circuits défaillants. Il se pose alors un problème de la destination des circuits défaillants qui doivent être détruits pour éviter que les secrets qu'ils contiennent puissent être percés par des utilisateurs indélicats (pirates) récupérant les circuits défectueux. En effet, les défauts d'un circuit peuvent être suffisants pour empêcher un fonctionnement correct sans pour autant rendre impossible l'accès aux informations sensibles qu'il contient (par exemple, la lecture des zones de mémoire morte dans lesquelles ont été stockées, par fabrication, des clés secrètes).

Ce problème devient de plus en plus sensible avec la dispersion des lieux de fabrications des circuits intégrés qui entraîne que les plaquettes et circuits sont souvent traités par des sous-traitants plus ou moins contrôlables. Par exemple, l'envoi de plaquettes entières une fois testées à un sous-traitant pour découpe et mise en boîtier pose le problème de s'assurer que les circuits "encrés" soient bien détruits.

### Résumé de l'invention

Pour atteindre tout ou partie de ces objets ainsi que d'autres, la présente invention prévoit un procédé de protection d'au moins un élément d'un circuit intégré, consistant à conditionner le fonctionnement de l'élément à protéger, à l'état d'un signal conditionné par un élément à programmation irréversible dont l'état est fixé lors d'un test sous pointes du circuit intégré.

Selon un mode de mise en oeuvre de la présente invention, l'état de l'élément de programmation est fixé par application d'un signal de programmation sur un plot que comporte le circuit intégré et qui n'est pas destiné à être accessible de l'extérieur une fois le circuit en boîtier.

Selon un mode de mise en oeuvre de la présente invention, un circuit de protection du circuit intégré est sélectionnable par un signal contenu dans un registre d'activation de l'élément à programmation irréversible.

L'invention prévoit également un circuit intégré, comportant au moins un élément de protection d'accès à au moins une fonction du circuit, dont l'état est programmé de façon irréversible par application d'un signal sur un plot que comporte le circuit lors d'un test sous pointes.

Selon un mode de réalisation de la présente invention, ledit élément de protection comporte au moins :
un élément à programmation irréversible ;
un élément de lecture de l'état de l'élément de programmation ; et
un élément de sélection du circuit de protection.

### Brève description des dessins

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente, de façon très schématique, un exemple de système de test de circuits intégrés en plaquette du type auquel s'applique la présente invention ;
la figure 2 représente un mode de réalisation d'un circuit de protection d'un circuit intégré selon la présente invention ;
la figure 3 représente partiellement un mode de réalisation d'une architecture de circuit intégré selon la présente invention ; et
la figure 4 est un organigramme simplifié illustrant un mode de mise en oeuvre du procédé de protection d'un circuit intégré selon l'invention.

Les mêmes éléments ont été désignés par les mêmes références aux différentes figures. Pour des raisons de clarté, seuls les éléments qui sont nécessaires à la compréhension de l'invention ont été représentés et seront décrits par la suite. En particulier, l'outil de test par plaquettes entières n'a pas été détaillé, l'invention étant compatible avec l'utilisation d'outils classiques. De plus, la structure interne du circuit intégré à protéger n'a été détaillée que pour exposer certains exemples de réalisation.

### Description détaillée

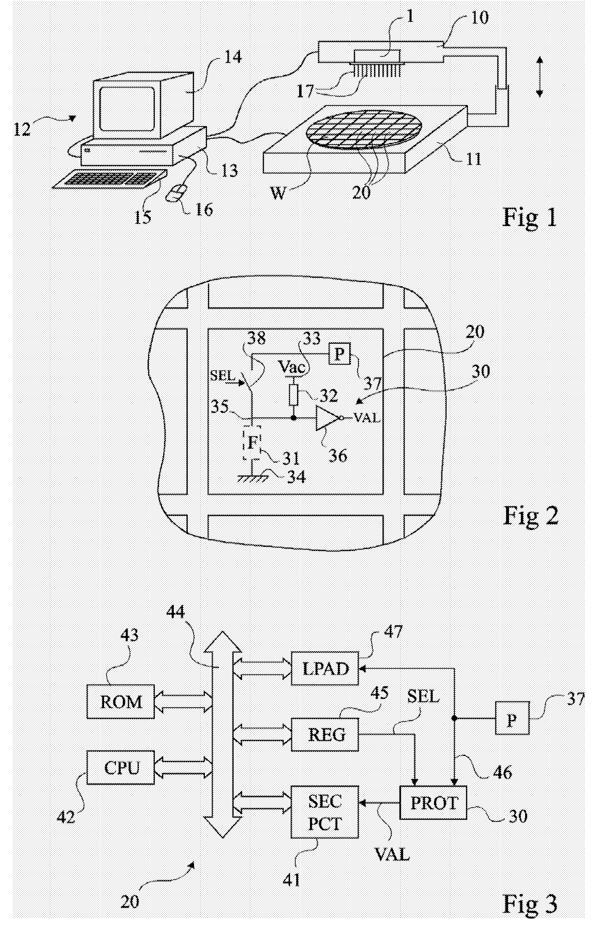

La figure 1 représente, de façon très schématique et sous forme de blocs, un exemple de système de test auquel s'applique la présente invention. Un tel système est basé sur l'utilisation d'une carte à pointes 1 comportant un ou plusieurs sites de test, portée par une tête de test 10 d'un outil, sur un support 11 duquel repose une plaquette W de circuits intégrés à tester. La tête 10 de test est articulée au moins verticalement par rapport au support 11 de manière à pouvoir approcher et écarter la carte à pointes 1 après introduction d'une nouvelle plaquette W à tester. L'ensemble est généralement commandé par un élément informatique, par exemple, un microordinateur 12 ou analogue pourvu d'une unité centrale 13, d'un écran 14, d'un clavier 15, et d'une souris 16 ou autres moyens de commande et de saisie.

L'objectif du système de test de la figure 1 est de tester un ou plusieurs des circuits intégrés 20 réalisés dans la plaquette W au moyen de contacts assurés par des pointes 17 de la carte 1. Ces pointes 17 sont réparties selon le motif de plots de contact (non représentées en figure 1) des circuits intégrés à tester. Les tests fonctionnels comprennent, par exemple, des tests de continuité électrique, des tests de mémorisation correcte d'informations, d'exécution correcte de calculs, etc. qui dépendent de la structure du circuit intégré 20 et de sa destination (l'application ou les applications auxquelles il est destiné).

Une fois testés, les différents circuits intégrés 20 portés par une même plaquette W sont découpés puis mis en boîtier.

Pour éviter que des informations sensibles (par exemple, des clés ou des algorithmes) intégrées dans les circuits 20 soient susceptibles d'être piratées à partir de circuits déclarés défectueux, l'invention prévoit, selon un mode de réalisation préféré, d'invalider le fonctionnement de tout ou partie du circuit intégré par une commande électrique effectuée en fin de test sous pointes.

La figure 2 illustre, de façon partielle et très schématique, un mode de réalisation d'un circuit 30 de protection d'au moins une zone sécurisée d'un circuit intégré 20 selon la présente invention. Le circuit 30 est destiné à fournir un signal VAL conditionnant le fonctionnement d'une zone sécurisée du circuit (non représentée en figure 2) dont l'état est conditionné par l'état d'un élément fusible ou anti-fusible 31 (F), ou équivalent. Par équivalent à élément fusible 31, on entend tout élément de conduction électrique dont l'état conducteur ou l'amplitude de conduction peut être modifiée de façon irréversible indépendamment de l'alimentation du circuit.

Dans l'exemple fonctionnel de la figure 2, l'élément fusible 31 est, par exemple, un élément résistif formant avec un autre élément résistif 32 un pont diviseur entre deux bornes 33 et 34 d'application d'une tension d'alimentation Vcc, le point milieu 35 de cette association en série étant relié en entrée d'un élément de lecture 36 (par exemple, un inverseur) dont la sortie fournit le signal VAL. Selon l'état de l'élément fusible 31, l'état de sortie du signal VAL lorsque le circuit est soumis à une tension d'alimentation Vcc est bas ou haut. Ce signal peut alors servir à conditionner le fonctionnement d'une zone protégée du circuit ou de l'intégralité du circuit.

La programmation de l'élément fusible 31 en fin de test sous pointes est, selon ce mode de réalisation de l'invention, effectuée au moyen d'un plot 37 (P) prévu dans la surface du circuit intégré 20 pour recevoir une pointe 17 de l'outil de test, le plot 37 n'étant pas accessible de l'extérieur du circuit, une fois le circuit intégré mis en boîtier.

De préférence, le plot 37 relie le point 35 par l'intermédiaire d'un interrupteur 38 commandé par un signal SEL de sélection du circuit 30. Le signal SEL de sélection et l'interrupteur 38 servent notamment à effectuer des tests en parallèle de plusieurs circuits intégrés et à sélectionner, en fin de test, ceux dont l'élément fusible 31 doit être programmé ou non comme on le verra par la suite.

L'élément fusible 31 est, de préférence, un élément à programmation électrique sous l'application d'un courant ou d'une tension sur le plot 37 alors que l'interrupteur 38 est fermé. La programmation de l'élément 31 peut avoir pour effet d'ouvrir ou de fermer le circuit électrique qu'il définit et plus généralement d'en augmenter ou d'en diminuer la résistance de façon à conditionner l'état du signal VAL de sortie de l'élément de lecture 36.

Tout élément dont un changement d'état est irréversible pourra être utilisé. Il pourra s'agir d'un claquage d'un fusible par effet Joule, d'un fusible métallique ou en silicium polycristallin, d'une destruction d'une jonction par effet thyristor, d'une modification de la caractéristique résistive d'un élément due à un courant important, d'un claquage d'oxyde par champ électrique (antifusible MOS), etc.

La figure 3 illustre un exemple d'architecture partielle d'un circuit intégré selon un mode de réalisation de l'invention. Dans un mode de réalisation préféré, le circuit intégré 20 à protéger, ou dont une fonction de sécurité 41 (SEC FCT) est à protéger, comporte une unité centrale de traitement 42 (CPU) chargée d'exécuter des programmes stockés, par exemple, dans une mémoire morte 43 (ROM). L'ensemble des éléments de calcul communiquent par un ou plusieurs bus 44.

Pour la mise en oeuvre de ce mode de réalisation de l'invention, un circuit 30 (PROT) de protection, par exemple du type de celui décrit en relation avec la figure 2, est intégré dans le circuit 20. Dans le mode de réalisation de la figure 3, le signal SEL est fourni par un registre 45 (REG) programmable par le microprocesseur 42 et une entrée 46 du circuit 30, correspondant à la borne de l'interrupteur 38 (figure 2) dont l'état est conditionné par le signal SEL et qui est reliée au plot 37, se trouve également reliée à un circuit 47 communiquant avec le bus 44 pour recevoir des signaux provenant de l'unité centrale 42. Le circuit 47 constitue le circuit d'interface logique (LPAD) du plot 37.

Le signal VAL fourni par le circuit 30 est envoyé sur la fonction sécurisée 41 du circuit intégré 20. L'action prise pour bloquer le circuit si le fusible contenu dans le circuit 30 a été programmé (claqué) dépend du contenu du circuit 41 et du type de données (clé ou programme) à protéger. Par exemple, le signal VAL sert à :
réinitialiser l'unité centrale 42 afin d'arrêter son signal d'horloge ;
programmer dans un état inactif un signal interne au circuit 41 (signal de réinitialisation, d'horloge, bus de données connecté directement à la masse ou d'adresse, etc.) ;
court-circuiter l'alimentation du circuit intégré ;
bloquer un canal quelconque de communication, etc.

Le registre 45 sert de registre d'activation-désactivation du claquage du fusible du circuit 30. Ce registre est préférentiellement commandé par l'unité centrale 42, ce qui permet de désactiver le claquage du fusible pendant la phase de test ou si le circuit a été testé de façon correcte.

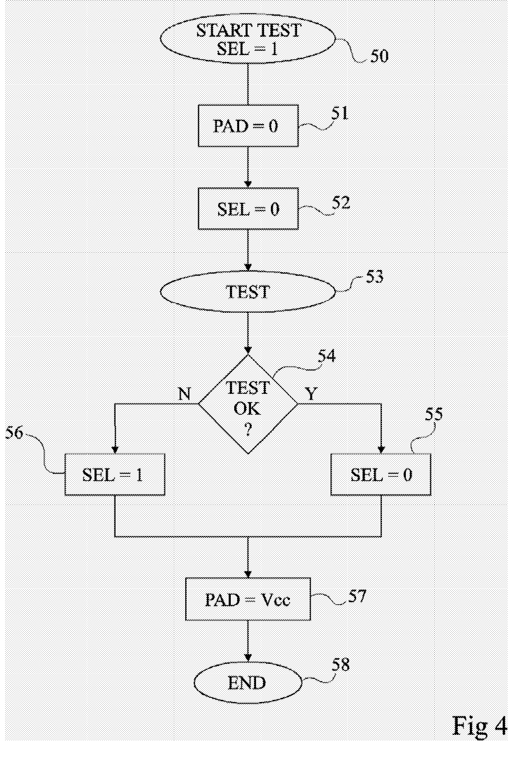

La figure 4 est un organigramme simplifié d'un mode de mise en oeuvre du procédé de protection selon l'invention.

Au démarrage d'un test d'une plaquette (bloc 50, START TEST) l'état du signal SEL de tous les circuits est actif (SEL = 1), ce qui représente l'état par défaut.

On positionne (bloc 51, PAD = 0), pour tous les circuits connectés en parallèle pour test par une carte à pointes 1, leurs plots 37 respectifs dans un état inactif (par exemple, bas). L'unité centrale 42 du circuit intégré ou un organe central de commande externe de l'outil de test positionne (bloc 52, SEL = 0) par ailleurs le bit de sélection conditionnant l'état de l'interrupteur 38 à l'état inactif.

Le test proprement dit peut alors débuter (bloc 53, TEST). Ce test est par exemple le test conduit classiquement pour le type de circuit considéré.

En fin de test, on vérifie (bloc 54, TEST OK ?) que le test conduit à un fonctionnement correct du circuit. Dans l'affirmative (bloc 55, SEL = 0), l'unité centrale 42 laisse le bit SEL contenu dans le registre 45 (figure 3) à l'état inactif. Si le test 54 est négatif (circuit défectueux), l'unité centrale 42 positionne (bloc 56, SEL = 1) le registre 45 dans l'état opposé et le signal de sélection SEL se trouve, pour le circuit intégré considéré de la plaquette, dans un état actif.

Pour tous les circuits (non fonctionnels) pour lesquels aucune programmation ne fonctionne, le signal SEL reste à l'état par défaut actif (l'étape 52 n'aboutit pas).

Puis (bloc 57, PAD = Vcc), on applique par l'intermédiaire de la carte à pointes, une tension de programmation (par exemple la tension Vdd) sur les plots 37 de tous les circuits testés en parallèle. Par les programmations respectives des registres 45 des différents circuits, seuls ceux dont le signal SEL est à l'état actif vont subir une programmation de leur élément fusible.

La phase de test et de protection est alors terminée (bloc 58, END).

D'autres séquences de test peuvent être prévues. Toutefois, un avantage de la séquence ci-dessus est de permettre l'utilisation du plot 37 pendant la phase de test.

Par la suite, les circuits subissent les traitements habituels. On peut par exemple maintenir un encrage des circuits défectueux pour préserver la reconnaissance optique lors de leur découpe et assemblage. Toutefois, tous les circuits considérés comme défectueux ont leur fonction de sécurité complètement invalide. En effet, grâce au claquage du fusible, l'application d'une tension électrique sur l'alimentation du circuit ne lui permettra pas de démarrer, le signal VAL inactivant de façon permanente et irréversible, quel que soit l'état ultérieur du bit SEL, un élément indispensable au fonctionnement du circuit ou au moins de sa fonction sécurisée.

Dans un mode de réalisation préféré de l'invention, l'interprétation du signal VAL ou sa logique d'obtention est telle que, après fabrication, l'application d'un signal sur le plot 37 conduit forcément à un blocage du circuit. Ainsi, même si un pirate parvient à accéder au plot pourtant inaccessible de l'extérieur du circuit intégré, cela ne lui permet pas de démarrer le circuit ou la fonction sécurisée. C'est le cas du mode de réalisation décrit en relation avec la figure 4 où l'état par défaut du signal SEL étant son état actif, tous les circuits se retrouvent pour le reste de leur vie avec un interrupteur 38 fermé. Par conséquent, polariser le plot 37 dans la vie du circuit claque le fusible et bloque le circuit.

Un avantage de la présente invention est que l'élément de protection 30 a, grâce à sa simplicité, peu de risque d'être lui-même défectueux. De plus, l'état par défaut actif du signal SEL participe à sa sécurité. Le cas échéant, plusieurs éléments 30 peuvent être prévus en parallèles pour réduire encore les risques.

Bien entendu, la présente invention est susceptible de diverses variantes et modifications qui apparaîtront à l'homme de l'art. En particulier, le choix du type d'élément fusible et de l'action effectuée par le circuit de protection dépend de l'application et est à la portée de l'homme du métier à partir des indications fonctionnelles données ci-dessus. De plus, bien que l'invention ait été décrite en relation avec un exemple dans lequel les circuits intégrés sont testés par groupes, l'invention s'applique également si les tests sont effectués individuellement pour chaque circuit de la plaquette, l'interrupteur de sélection 38 et le registre 45 étant alors optionnels, la programmation de l'élément fusible 31 pouvant s'effectuer par simple application d'un signal sur le plot 37.

## Revendications

1. Procédé de protection d'au moins un élément (41) d'un circuit intégré (20), **caractérisé en ce qu'**il consiste à conditionner le fonctionnement de l'élément à protéger, à l'état d'un signal (VAL) conditionné par un élément à programmation irréversible (31) dont l'état est fixé lors d'un test sous pointes du circuit intégré.

2. Procédé selon la revendication 1, dans lequel l'état de l'élément de programmation (31) est fixé par application d'un signal de programmation sur un plot (37) que comporte le circuit intégré et qui n'est pas destiné à être accessible de l'extérieur une fois le circuit en boîtier.

3. Procédé selon la revendication 1, dans lequel un circuit (30) de protection du circuit intégré est sélectionnable par un signal (SEL) contenu dans un registre (35) d'activation de l'élément à programmation irréversible.

4. Circuit intégré (20), **caractérisé en ce qu'**il comporte au moins un élément (30) de protection d'accès à au moins une fonction (41) du circuit, dont l'état est programmé de façon irréversible par application d'un signal sur un plot (37) que comporte le circuit lors d'un test sous pointes.

5. Circuit selon la revendication 4, dans lequel ledit élément de protection (30) comporte au moins :
un élément (31) à programmation irréversible ;
un élément (36) de lecture de l'état de l'élément de programmation ; et
un élément (38) de sélection du circuit de protection.
